# EUROPEAN PATENT APPLICATION

(11) **EP 2 066 158 A2**
(43) Date of publication of application: **03.06.2009**
(21) Application number: 08169809.4
(22) Date of filing: 24.11.2008
(51) Int. Cl.: H05K 1/14, H05K 3/46

(54) **Multilayer, thermally-stabilized substrate structures**

(30) Priority: 30.11.2007 US 948338
(71) Applicant: ITT Manufacturing Enterprises, Inc., Wilmington, Delaware 19801 (US)
(72) Inventor: Juett, Gregg T., Clearwater, FL 33756 (US)
(74) Representative: Esser, Wolfgang

(57) **Abstract**

A multilayer, thermally-stabilized substrate, including a thermally-conductive core structure (108), including a central section (112) located horizontally between two edge sections (114); a top multilayer circuit board (110) connected to the top surface of the central portion of the core structure; and a bottom multilayer circuit board (110) connected to the bottom surface of the central portion of the core structure. The core structure (108) has a core thermal conductance and a effective core horizontal thermal expansion coefficient. The top and bottom multilayer circuit boards (110) each include at least one dielectric layer (104) and at least one electrically-conductive layer (106), and each have a circuit board thermal conductance that is less than the core thermal conductance of the core structure. The electrically-conductive layers of the top and the bottom circuit boards each have a conductive layer horizontal thermal expansion coefficient that is less than or equal to the effective core horizontal thermal expansion coefficient of the core structure.

## Description

### FIELD OF THE INVENTION

The present invention concerns thermally-stabilized substrate structures having multiple layers. In particular, the present invention allows for the production of thermally-stabilized systems in a package (SIPs).

### BACKGROUND OF THE INVENTION

The demand for more and more complicated systems in a package (SIPs) that may be formed in a single integrated chip package is driven by a desire for more compact electronic devices, as well as simplifing post-fabrication assembly and packaging of these devices. Simplifying the assembly and packaging of electronic devices may improve durability and quality, as well as decrease the cost of manufacture of these devices.

An SIP typically includes multiple electronic components that are mounted on a multilayer substrate structure having one or more electrically-conductive layer(s) patterned to form circuit boards.

One difficulty that designers of such SIPs often face is ensuring thermal stability within these integrated chips. As both the density of component and the size of SIPs increases, maintaining thermal stability becomes more difficult. Two related problems that may be caused by excess heat generated by multiple components in densely packed SIPs are elevated operating temperatures and thermal expansion. Elevated operating temperatures may lead to decreased lifetimes for the electronic components and/or may affect the characteristics of these components during operation. As the densities of electronic components increase within SIPs this problem is likely to increase. Increasing the size of SIPs, while maintaining current component densities, may also exacerbate this problem.

Mismatches in thermal expansion coefficients of layers within the substrate and/or the electronic components on the substrate may lead to mechanical stresses. Temperature cycling may increase the effects of mechanical stresses on an SIP due to thermal expansion mismatches. These mechanical stresses may lead to damage such as permanent or intermittent breaks in lines of the circuit board and/or in the joints electrically coupling the components to the circuit board. Because thermal expansion is proportional to size, increasing the size of an SIP increases the thermal expansion mismatch within the structures of the SIP.

One approach to reducing thermal expansion mismatches involves improving heat conductance within the substrate structure of the circuit board in order to reduce temperature elevation during operation. For example, metal core substrates are used in circuit board construction for improving heat conductance within the substrate structure. In larger, more densely packed SIPs, however, it may be difficult to prevent temperature elevation during operation and the circuit board and electronic components may still encounter significant mechanical stresses due to the resulting temperature cycling.

The present invention includes a new approach to thermally-stabilizing substrate structures of circuit boards used in SIPs.

### SUMMARY OF THE INVENTION

An exemplary embodiment of the present invention is a multilayer, thermally-stabilized substrate, including: a thermally-conductive core structure, including a central section located horizontally between two edge sections; a top multilayer circuit board connected to the top surface of the central portion of the thermally-conductive core structure; and a bottom multilayer circuit board connected to the bottom surface of the central portion of the thermally-conductive core structure. The thermally-conductive core structure has a core thermal conductance and a effective core horizontal thermal expansion coefficient. The top and bottom multilayer circuit boards each include at least one dielectric layer and at least one electrically-conductive layer, and each have a circuit board thermal conductance that is less than the core thermal conductance of the thermally-conductive core structure. The electrically-conductive layers of the top and the bottom multilayer circuit boards each have a conductive layer horizontal thermal expansion coefficient that is less than or equal to the effective core horizontal thermal expansion coefficient of the thermally-conductive core structure.

Another exemplary embodiment of the present invention is a thermally-stabilized system in a package (SIP) including: a multilayer, thermally-stabilized substrate; a plurality of electronic components; and a chip package adapted to hold the multilayer, thermally-stabilized substrate. The multilayer, thermally-stabilized substrate includes: a thermally-conductive core structure, including a central section located horizontally between two edge sections; a top multilayer circuit board connected to the top surface of the central portion of the thermally-conductive core structure; and a bottom multilayer circuit board connected to the bottom surface of the central portion of the thermally-conductive core structure. The thermally-conductive core structure has a core thermal conductance and a effective core horizontal thermal expansion coefficient. The top multilayer circuit board includes at least one dielectric layer and at least one patterned electrically-conductive layer. The bottom multilayer circuit board includes at least one dielectric layer and at least one electrically-conductive layer. The top and bottom multilayer circuit boards each have a circuit board thermal conductance that is less than the core thermal conductance of the thermally-conductive core structure. The electrically-conductive layers of the top and the bottom multilayer circuit boards each have a conductive layer horizontal thermal expansion coefficient that is less than or equal to the effective core horizontal thermal expansion coefficient of the thermally-conductive core structure of the multilayer, thermally-stabilized substrate. The electronic components are mounted on the top multilayer circuit board and electrically coupled to the patterned electrically-conductive layer(s) of the the top multilayer circuit board. The chip package includes a heat sink that is thermally coupled to the two edge sections of the thermally-conductive core structure of the multilayer, thermally-stabilized substrate.

### BRIEF DESCRIPTION OF THE DRAWINGS

The invention may be best understood from the following detailed description when read in connection with the accompanying drawings. It is emphasized that, according to common practice, the various features of the drawings are not to scale. On the contrary, the dimensions of the various features are arbitrarily expanded or reduced for clarity. Included in the drawing are the following FIGS.:
FIG. 1 is a side plan drawing illustrating an exemplary multilayer, thermally-stabilized substrate according to an embodiment of the present invention.
FIG. 2 is a top plan drawing illustrating an exemplary thermally-stabilized system in a package (SIP) according to an embodiment of the present invention.
FIG. 3 is a side plan drawing illustrating another exemplary thermally-stabilized SIP according to an embodiment of the present invention.

### DETAILED DESCRIPTION OF THE INVENTION

Exemplary embodiments of the present invention include the use of multilayer substrate structures to improve the thermal stability of systems in a package (SIPs). These exemplary multilayer substrate structures include a core structure that is thermally-conductive and multilayer circuit boards disposed symmetrically above and below the core structure. The core structure and the multilayer circuit boards are configured such that the thermal expansion coefficient in the horizontal plane of the core structure is less than or equal to the thermal expansion coefficient of a respective horizontal plane of the electrically-conductive layers of the multilayer circuit boards.

The high thermal conductivity of the core structure provides an effective route for heat dissipation during operation, thereby helping to reduce temperature elevation. The formation of the core structure with a relatively low horizontal thermal expansion coefficient helps prevent the insulating layers from excessively expanding and contracting during temperature cycling. Thus, stresses on the conductive layers of the multilayer circuit boards due to thermal expansion is desirably reduced in exemplary embodiments of the present invention.

It is noted that the terms horizontal, vertical, above, below, side, top, and bottom are used throughout these specification and claims to refer to directions and dimensions of exemplary embodiments of the present invention. These terms are used for convenience of explanation with reference to the orientation of the exemplary embodiments as shown in the FIGS. and are not intended to be limiting.

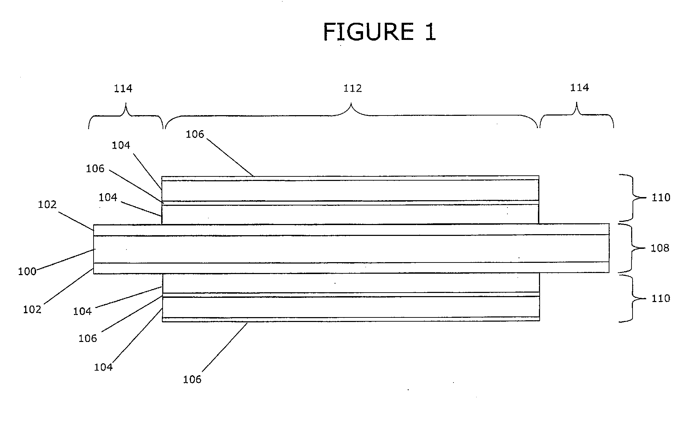

FIG. 1 illustrates an exemplary multilayer, thermally-stabilized substrate according to an embodiment of the present invention. This multilayer, thermally-stabilized substrate includes thermally-conductive core structure 108 and top and bottom multilayer circuit boards 110.

Thermally-conductive core structure 108 includes central section 112, which is located horizontally between two edge sections 114. Top and bottom multilayer circuit boards 110 are arranged on the top and bottom surface, respectively, of central section 112 of thermally-conductive core structure 108. As another embodiment, these multilayer circuit boards may be formed, or laminated, over the entire top and bottom surfaces of thermally-conductive core structure 108 and then removed from edges sections 114 of thermally-conductive core structure 108. Alternatively, multilayer circuit boards 110 may be formed, or laminated, over only central section 112 of thermally-conductive core structure 108.

Thermally-conductive core structure 108 has a thermal conductance that is relatively high, desirably at least 200 W/K, to allow heat generated by electronic components mounted on the circuit boards to be removed from central section 112 and flow toward edge sections 114, which may be thermally coupled to a heat sink. Thermally-conductive core structure 108 has an effective horizontal thermal expansion coefficient that is less than or equal to the horizontal thermal expansion coefficient of electrically-conductive layers 106 of multilayer circuit boards 110.

The horizontal thermal expansion coefficient of thermally-conductive core structure 108 is desirably less than or equal to the horizontal thermal expansion coefficient of the electrically-conductive layers of multilayer circuit boards 110. In exemplary embodiments on the present invention, multilayer circuit boards 110 and possibly thermally-conductive core structure 108 are formed of multiple horizontally homogenous layers. It is only in the horizontal direction, therefore, that thermal expansion mismatches between the layers lead to undesired mechanical stresses according to an embodiment of the present invention.

In addition, it is the effective horizontal thermal expansion coefficient of thermally-conductive core structure 108 that is taken into account in the exemplary embodiments of the present invention. In the case where thermally-conductive core structure 108 is formed of a single layer, however, this distinction may be unnecessary. In the case where thermally-conductive core structure 108 is formed of multiple layers, as shown in FIG. 1, the different core layers may have different thermal expansion coefficients. In this latter case, the overall horizontal thermal expansion of core structure 108 may be based on several properties of the different core layers, such as thickness and elasticity of the layers, as well as their thermal expansion coefficients. An effective horizontal thermal expansion coefficient of the entire thermally-conductive core structure may be determined to take these properties into account and it this parameter that illustrates the effect of thermally-conductive core structure 108 on the thermal expansion of multilayer circuit boards 110.

As noted above, thermally-conductive core structure 108 may be formed of a single layer; however, it may also be a multilayer structure, as shown in FIG. 1. As shown, the thermally-conductive core structure includes: middle core layer 100; and top and bottom core cladding layers 102 formed on the top and bottom surfaces, respectively, of middle core layer 100. It is noted that top and bottom core cladding layers 102 are desirably formed symmetrically about middle core layer 100. This symmetric construction reduces the possibility of thermally-conductive core structure 108 bowing during changes in temperature due to any non-symmetric thermal expansion of the top and bottom cladding layers.

The materials and thicknesses of middle core layer 100 and core cladding layers 102 may be selected such that: the thermal conductance of thermally-conductive core structure 108 is equal to the desired core thermal conductance; and the effective horizontal thermal expansion coefficient of thermally-conductive core structure 108 is equal to the desired effective core horizontal thermal expansion coefficient. Although the exemplary embodiment of FIG. 1 includes only one top core cladding layer and one bottom core cladding layer, this is for illustrative purposes only and is not intended to be limiting. One skilled in the art will understand that multiple pairs of cladding layers, formed of various materials having various thicknesses, may be used in thermally-conductive core structure 108.

In the case of a single layer thermally-conductive core structure, the layer may be formed of the same material as the electrically-conductive layer(s) of the multilayer circuit boards. Although this layer may be formed of any material that has the desired thermal properties, this layer is typically formed of materials that are metallic. In the case of multilayer thermally-conductive core structures, the materials and thicknesses of the layers may be selected to provide the desired thermal properties. These layers may include metallic layers, non-metallic layers, or a combination of metallic and non-metallic layers. In one exemplary embodiment, middle core layer 100 may be formed of molybdenum and core cladding layers 102 may be formed of copper. Copper has very high thermal conductivity and molybdenum has a very low thermal expansion coefficient (as well as good thermal conductivity) and is very stiff. Thus, the copper cladding layers insure that the exemplary thermally-conductive core structure has sufficient thermal conductivity and the molybdenum middle layer provides a stiff backbone that reduces expansion or contraction during temperature cycling of the exemplary multilayer, thermally-stabilized substrate.

It is noted that thermally-conductive core structure 108 may be electrically-conductive as well as thermally-conductive. Thus, two edge sections 114 of thermally-conductive core structure 108 may be electrically-coupled to a reference voltage, such as ground. The thermally-conductive core structure may act as a ground plane for electronic components mounted on one or both multilayer circuit boards 110, and/or may act as an electrical shield for electronic components mounted on opposite multilayer circuit boards 110.

Multilayer circuit boards 110 each include at least one dielectric layer 104 and at least one electrically-conductive layer 106. One skilled in the art will understand that, although each multilayer circuit board 110 in the exemplary embodiment of FIG.1 includes two dielectric layers 104 alternating with two electrically-conductive layers 106, other layer configurations of multilayer circuit boards 110 may be used in the present invention. For example, an exemplary multilayer circuit board may be formed with a single dielectric layer 104 and a single electrically-conductive layers 106. In another exemplary embodiment, the multilayer circuit board may be formed with three or more alternating sets of dielectric layers 104 and electrically-conductive layers 106. In a further exemplary embodiment, the multilayer circuit board may be formed with multiple dielectric layers 104 topped by a single electrically-conductive layers 106.

Electrically-conductive layers 106 may include any electrically conductive material; however, metallic layers, such as copper foil, may be most common. At least one of electrically-conductive layers 106 is desirably patterned to form conductive traces.

Dielectric layers 104 may be formed of any material used in circuit board fabrication including: a fiberglass material; a ceramic material; alumina; beryllium oxide; polyimide; phenol; polytetrafluoroethylene; and/or resin epoxies, among others. Dielectric layers 106 may include vias to allow electrical couplings, such as: deeper coupling of electronic components to electrically-conductive layers 106 within the multilayer circuit boards 110; electrical coupling of electronic components to thermally-conductive core structure 108 (if thermally-conductive core structure 108 is electrically conductive); and electrical coupling between electrically-conductive layers 106 and/or thermally-conductive core structure 108. Vias may also be use to provide increased thermal coupling between electronic components and thermally-conductive core structure 108.

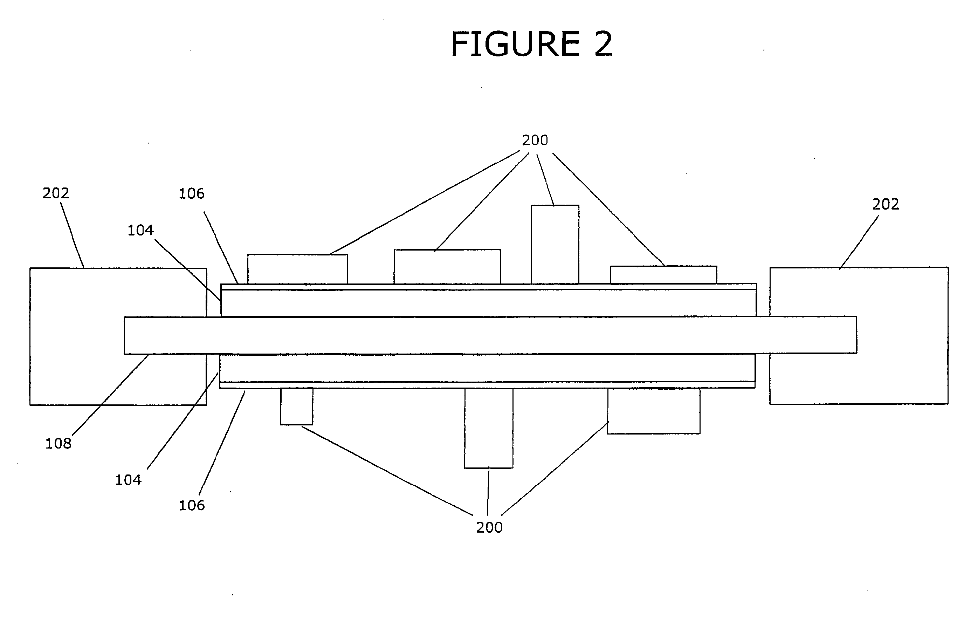

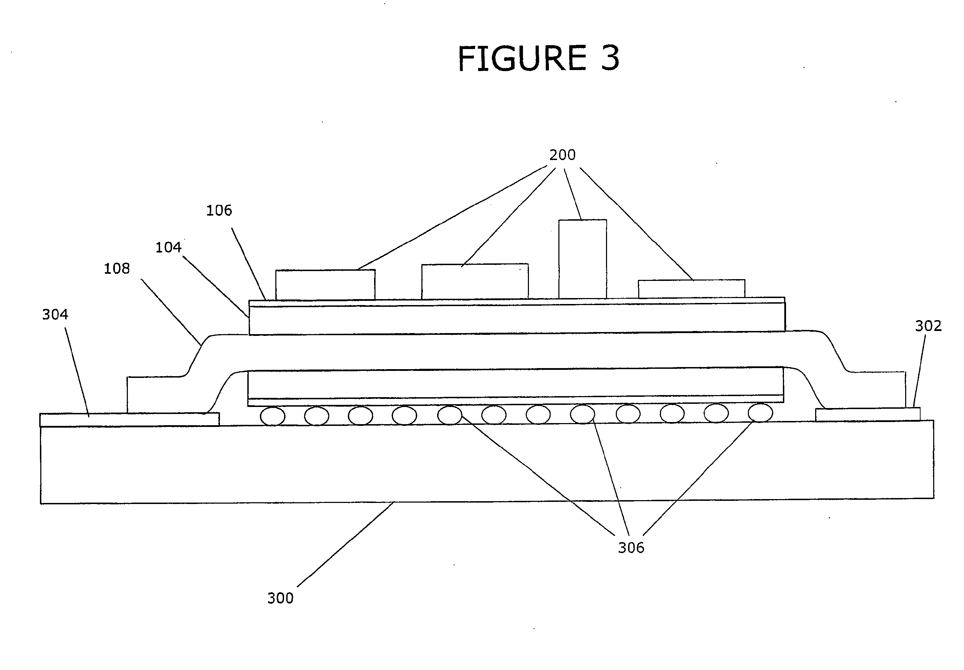

FIGS. 2 and 3 exemplify two thermally-stabilized SIPs according to an embodiment of the present invention. These thermally-stabilized SIPs include a chip package that is adapted to hold a multilayer, thermally-stabilized substrate, as described above with reference to FIG. 1. This chip package includes, among other features, a heat sink that is thermally coupled to the two edge sections of thermally-conductive core structure 108. In these embodiments, the multilayer circuit boards of the multilayer, thermally-stabilized substrate include a single dielectric layer 104 and a single electrically-conductive layer 106. Moreover, thermally-conductive core structure 108 is illustrated as a single core layer. The number of substrate layers illustrated in FIGS. 2 and 3 have been selected for illustrative purposes and are not intended to be limiting.

The exemplary thermally-stabilized SIP of FIG. 2 includes: a multilayer, thermally-stabilized substrate as described above with reference to FIG. 1; electronic components 200 mounted on both multilayer circuit boards of the multilayer, thermally-stabilized substrate; and a pair of heat sinks 202, which are coupled to the edge sections of thermally-conductive core structure 108. In this exemplary embodiment, both electrically-conductive layers 106 are desirably patterned. It is noted , however, that, in another embodiment in which electronic components 200 are coupled only to the top multilayer circuit board of the multilayer, thermally-stabilized substrate, electrically-conductive layer 106 of the bottom multilayer circuit board is desirably not patterned.

Electronic components 200 may be any type of electronic components, including discrete elements and integrated circuits. These components may be electrically coupled to one of patterned electrically-conductive layers 106 and may also be electrically coupled to thermally-conductive core structure 108, if it is electrically conductive.

In the exemplary embodiment of FIG. 2, heat sinks 202 of the chip package are illustrated. One skilled in the art will understand the chip package may include a number of other elements, such as a base and cover to encapsulate the SIP and a number of electrodes coupled to electrically-conductive layers 106 (possibly including a reference voltage electrode coupled to thermally-conductive core structure 108 and/or electrically-conductive layers 106). Chip package electrodes may be coupled to electrically-conductive layers 106 (and possibly to thermally-conductive core structure 108) using standard methods known in the chip fabrication industry, such as wire-bonding and soldering.

Although heat sinks 202 of FIG. 2 are adapted to mechanically hold the multilayer, thermally-stabilized substrate within the chip package, it is contemplated that a separate substrate holder may be included as part of the present invention.

Heat sinks 202 desirably have a large heat capacity and high heat conductivity. They may also desirably include fins or other standard means to dissipate excess heat into the environment. These heat sinks are arranged to couple thermally-conductive core structure 108 to the chip package (not shown. There are a number of ways of thermally coupling specific heat sinks 202 to thermally-conductive core structure 108. For example, each heat sink may include a thermally-conductive clamp adapted to clamp one of the edge sections of thermally-conductive core structure 108. These clamps may be spring loaded or may include a set screw. Alternatively, each heat sink may include a thermally-conductive slot adapted to slidably engage one of the edge sections of thermally-conductive core structure 108.

If thermally-conductive core structure 108 of the multilayer, thermally-stabilized substrate is electrically-conductive, a reference voltage electrode may be coupled to the two edge sections of thermally-conductive core structure 108 through heat sinks 202.

FIG. 3 illustrates another exemplary thermally-stabilized SIP according to an embodiment of the present invention. In this embodiment, both top and bottom electrically-conductive layers 106 are desirably patterned and these patterned layers are desirably electrically coupled. Electronic components 200, as shown, are mounted only on top electrically-conductive layer 106. Bottom electrically-conductive layer 106 is electrically coupled to a plurality of electrodes in base 300 of the chip package using ball grid array interconnects 306.

As shown in FIG. 3, the edge sections of thermally-conductive core structure 108 of the multilayer, thermally-stabilized substrate is thermally coupled to heat sinks 302 and 304. In one exemplary embodiment, the chip package may include a clamp to press the multilayer, thermally-stabilized substrate onto base 300 so that the edge sections of thermally-conductive core structure 108 are held in contact with heat sinks 302 and 304. Alternatively, a cover of the chip package (not shown) may perform this function by pressing down on the multilayer, thermally-stabilized substrate.

Alternatively, the edge sections of thermally-conductive core structure 108 may be thermally, and mechanically, coupled to heat sinks 302 and 304 of the chip package using thermally-conductive epoxy. If thermally-conductive core structure 108 includes a metallic layer, its two edge sections may desirably be soldered to heat sinks 302 and 304 of the chip package to provide high thermal conductivity and solid mechanical coupling.

As shown in FIG. 3, heat sink 304 includes an extended portion that may be used as a reference voltage electrode. If thermally-conductive core structure 108 is electrically conductive and heat sink 304 is used as a reference voltage electrode to electrically couple thermally-conductive core structure 108 to a reference voltage, then soldering may be a desirable method of coupling these elements. It is noted, however, that thermally- and electrically- conductive epoxies may also be used.

It is noted that FIG. 3 illustrates edge sections of thermally-conductive core structure 108 bending down coupling to heat sinks 302 and 304 which have low profiles on the flat surface of base 300. One skilled in the art will understand that this is merely illustrative and that other configurations are also possible. For example, heat sinks 302 and 304 may be taller, or base 300 may include raised portions corresponding to the edge sections of thermally-conductive core structure 108 so that thermally-conductive core structure 108 may remain flat.

The present invention includes a number of exemplary embodiments. Although the invention is illustrated and described herein with reference to specific embodiments, it is not intended to be limited to the details shown. Rather, various modifications may be made in the details within the scope and range of equivalents of the claims and without departing from the invention. In particular, one skilled in the art may understand that many features of the various specifically illustrated embodiments may be mixed to form additional exemplary multilayer, thermally-stabilized substrates and/or thermally-stabilized SIPs also embodied by the present invention.

## Claims

1. A multilayer, thermally-stabilized substrate comprising:
a thermally-conductive core structure (108) including a central section located horizontally between two edge sections, the thermally-conductive core structure (108) having a core thermal conductance and a effective core horizontal thermal expansion coefficient;
a top multilayer circuit board (110) connected to a top surface of the central portion of the thermally-conductive core structure (108), the top multilayer circuit board including at least one dielectric layer (104) and at least one electrically-conductive layer (106); and
a bottom multilayer circuit board (110) connected to a bottom surface of the central portion of the thermally-conductive core structure (108), the bottom multilayer circuit board including at least one dielectric layer (104) and at least one electrically-conductive layer (106); wherein:
the top multilayer circuit board (110) and the bottom multilayer circuit board (110) each have a circuit board thermal conductance that is less than the core thermal conductance of the thermally-conductive core structure (108); and
the at least one electrically-conductive layer (106) of the top multilayer circuit board and the at least one electrically-conductive layer (106) of the bottom multilayer circuit board each have a conductive layer horizontal thermal expansion coefficient that is less than or equal to the effective core horizontal thermal expansion coefficient of the thermally-conductive core structure (108).

2. A multilayer, thermally-stabilized substrate according to claim 1, wherein:
the thermally-conductive core structure (108) is a multilayer structure including a middle core layer (100);
at least one top core cladding layer (102) formed on a top surface of the middle core layer; and
at least one bottom core cladding layer (102) formed on a bottom surface of the middle core layer;
the at least one top core cladding layer and the at least one bottom core cladding layer (102) are formed symmetrically around the middle core layer (110); and
materials and thicknesses of the middle core layer (110), the at least one top core cladding layer, and the at least one bottom core cladding layer are selected such that:
a thermal conductance of the thermally-conductive core structure (108) is equal to the core thermal conductance; and
an effective horizontal thermal expansion coefficient of the thermally-conductive core structure (108) is equal to the effective core horizontal thermal expansion coefficient.

3. A multilayer, thermally-stabilized substrate according to claim 1 or 2,
wherein the middle core layer (100) of the the thermally-conductive core structure (108) is formed of a metallic material.

4. A multilayer, thermally-stabilized substrate according to claim 1 or 2,
wherein:
the at least one top and bottom core cladding layer (102, 102) includes at least one metallic layer.

5. A multilayer, thermally-stabilized substrate according to claim 1 or 2,
wherein:
the middle core layer (100) is formed of molybdenum;
the at least one top and bottom core cladding layer (102, 102) includes a copper layer.

6. A multilayer, thermally-stabilized substrate according to at least one of claims 1 to 5, wherein the thermally-conductive core (108) structure is electrically-conductive.

7. A multilayer, thermally-stabilized substrate according to claim 6, wherein two edge sections (114) of the thermally-conductive core structure (108) (108) are adapted to be electrically-couplable to a reference voltage.

8. A multilayer, thermally-stabilized substrate according to at least one of claims 1 to 7, wherein two edge sections (114) of the thermally-conductive core structure (108) are adapted to be thermally couplable to a heat sink (202).

9. A multilayer, thermally-stabilized substrate according to claim 1, wherein the core thermal conductance of the thermally-conductive core structure (108) is greater than or equal to about 200 W/K.

10. A multilayer, thermally-stabilized substrate according to claim 1, wherein:
the at least one dielectric layer (104) of the top multilayer circuit board (110) includes at least one of: a fiberglass layer; a ceramic layer; an alumina layer; a beryllium oxide layer; a polyimide layer; a phenol layer; a polytetrafluoroethylene layer; or a resin epoxy layer; and
the at least one dielectric layer (104) of the bottom multilayer circuit board (110) includes at least one of: a fiberglass layer; a ceramic layer; an alumina layer; a beryllium oxide layer; a polyimide layer; a phenol layer; a polytetrafluoroethylene layer; or a resin epoxy layer.

11. A multilayer, thermally-stabilized substrate according to claim 1, wherein:
the at least one electrically-conductive layer of the top multilayer circuit board (110) includes at least one metallic layer; and
the at least one electrically-conductive layer of the bottom multilayer circuit board (110) includes at least one metallic layer.

12. A multilayer, thermally-stabilized substrate according to claim 11, wherein:
the at least one metallic layer of the top and bottom multilayer circuit board (110) is at least one copper foil layer.

13. A multilayer, thermally-stabilized substrate according to claim 1, wherein the at least one electrically-conductive layer (106) of the top multilayer circuit board (110) includes at least one patterned electrically-conductive layer.

14. A thermally-stabilized system in a package (SIP) comprising:
a multilayer, thermally-stabilized substrate including:
a thermally-conductive core structure (108) including a central section (112) located horizontally between two edge sections 8114), the thermally-conductive core structure (108) having a core thermal conductance and a effective core horizontal thermal expansion coefficient;
a top multilayer circuit board (110) connected to a top surface of the central portion of the thermally-conductive core structure (108), the top multilayer circuit board (110) including at least one dielectric layer (104) and at least one patterned electrically-conductive layer (106); and
a bottom multilayer circuit board (110) connected to a bottom surface of the central portion of the thermally-conductive core structure (108), the bottom multilayer circuit board (110) including at least one dielectric layer (104) and at least one electrically-conductive layer (106);
a plurality of electronic components (200) mounted on the top multilayer circuit board (110) and electrically coupled to the at least one patterned electrically-conductive layer (106) of the the top multilayer circuit board; and
a chip package adapted to hold the multilayer, thermally-stabilized substrate, the chip package including a heat sink (202, 302) that is thermally coupled to the two edge sections (114) of the thermally-conductive core structure (108) of the multilayer, thermally-stabilized substrate;
wherein:
the top multilayer circuit board (110) and the bottom multilayer circuit board (110) of the multilayer, thermally-stabilized substrate each have a circuit board thermal conductance that is less than the core thermal conductance of the thermally-conductive core structure (108) of the multilayer, thermally-stabilized substrate; and
the at least one electrically-conductive layer (106) of the top multilayer circuit board (110) and the at least one electrically-conductive layer (106) of the bottom multilayer circuit board (110) of the multilayer, thermally-stabilized substrate each have a conductive layer horizontal thermal expansion coefficient that is less than or equal to the effective core horizontal thermal expansion coefficient of the thermally-conductive core structure (108) (108) of the multilayer, thermally-stabilized substrate.

15. A thermally-stabilized SIP according to claim 14, wherein:
the thermally-conductive core structure (108) of the multilayer, thermally-stabilized substrate is electrically-conductive;
the chip package further includes a reference voltage electrode; and
the two edge sections (114) of the thermally-conductive core structure (108) of the multilayer, thermally-stabilized substrate are electrically coupled to the reference voltage electrode of the chip package.

16. A thermally-stabilized SIP according to claim 14, wherein the at least one electrically-conductive layer (106) of the bottom multilayer circuit board (110) of the multilayer, thermally-stabilized substrate includes at least one patterned electrically conductive layer.

17. A thermally-stabilized SIP according to claim 16, further comprising another plurality of electronic components (200) mounted on the bottom multilayer circuit board (110) and electrically coupled to the at least one patterned electrically-conductive layer (106) of the the bottom multilayer circuit board.

18. A thermally-stabilized SIP according to claim 16, wherein the at least one patterned electrically-conductive layer (106) of the the bottom multilayer circuit board (110) is electrically coupled to the at least one patterned electrically-conductive layer of the the top multilayer circuit board.

19. A thermally-stabilized SIP according to claim 16, wherein:
the chip package further includes a plurality of electrodes; and
the at least one patterned electrically-conductive layer of the the bottom multilayer circuit board (110) is electrically coupled to the plurality of electrodes of the chip package using ball grid array interconnects.

20. A thermally-stabilized SIP according to claim 14, wherein:
the chip package further includes a plurality of electrodes; and
the at least one patterned electrically-conductive layer of the the top multilayer circuit board (110) is electrically coupled to the plurality of electrodes of the chip package.

21. A thermally-stabilized SIP according to claim 14, wherein:
the thermally-conductive core structure (108) of the multilayer, thermally-stabilized substrate includes a metallic layer; and
the two edge sections of the thermally-conductive core structure (108) of the multilayer, thermally-stabilized substrate are soldered to the heat sink of the chip package.

22. A thermally-stabilized SIP according to claim 14, wherein the two edge sections of the thermally-conductive core structure (108) of the multilayer, thermally-stabilized substrate are thermally coupled to the heat sink of the chip package using thermally conductive epoxy.

23. A thermally-stabilized SIP according to claim 14, wherein the heat sink of the chip package includes two thermally-conductive clamps arranged to couple the thermally-conductive core structure (108) of the multilayer, thermally-stabilized substrate to the chip package, each thermally-conductive clamp adapted to clamp one of the two edge sections of the thermally-conductive core structure (108) of the multilayer, thermally-stabilized substrate.

24. A thermally-stabilized SIP according to claim 14, wherein the heat sink of the chip package includes two thermally-conductive slots arranged to couple the thermally-conductive core structure (108) of the multilayer, thermally-stabilized substrate to the chip package, each thermally-conductive slot adapted to slideably engage one of the two edge sections of the thermally-conductive core structure (108) of the multilayer, thermally-stabilized substrate.
